# EUROPEAN PATENT APPLICATION

(11) **EP 2 508 575 A1**
(43) Date of publication of application: **10.10.2012**
(21) Application number: 11161141.4
(22) Date of filing: 05.04.2011
(51) Int. Cl.: C09D 11/00

(54) **Radiation curable compositions**

(71) Applicant: Cytec Surface Specialties, S.A., 1070 Brussels (BE)
(72) Inventor: Van den Bergen, Hugues, 1620 Drogenbos (BE); Gevaert, Paul, 9500 Geraardsbergen (BE); Clark, Graham, 3090 Overijse (BE); De Waele, Luc, 9400 Denderwindeke (BE)
(74) Representative: Schoofs, Hilde

(57) **Abstract**

The present invention relates radiation curable composition comprising at least one ethylenically unsaturated compound (A); at least one inert polyester resin (B); and at least one inert resin (C) different from (B).

These present invention further relates to their preparation and their uses, especially in inks.

## Description

The present invention relates to radiation curable compositions comprising inert resins that are suitable for use on various substrates, including plastic substrates; to their preparation and their uses.

Commercially available UV flexographic inks have limited adhesion on flexible plastic substrates. Especially adhesion on non-polar plastic substrates is poor.

It is theoretically possible to increase adhesion on plastics by using "inert" resins diluted in monomers, but hereby the UV reactivity often significantly decreases. W02008/015474 & WO2008/004002 disclose printing inks with inert resins dissolved in e.g. tetrahydrofurfurylacrylate, N-vinyl caprolactam and phenoxyethyl acrylate. The inks disclosed herein are not suited for flexographic applications and/or for use in food-packaging due to a too low UV reactivity and migration of uncured monomers.

The UV reactivity can be increased by adding multifunctional acrylates, but this has a negative impact on adhesion due to shrinkage increase after curing.

For that reason, an adhesion primer is currently applied on the plastic substrate to increase adhesion before applying the UV curable flexographic ink.

There is thus a need for radiation curable inks binders with improved adhesion to plastic substrates and advantageously an acceptable UV reactivity, good pigment wetting properties and medium viscosity. If no primer is needed the application process is easier and/or more cost effective.

The UV curable ink binders and inks of the present invention provide a solution to one or more of the above problems.

Against this background we now provide a radiation curable composition comprising at least one ethylenically unsaturated compound (A) and at least two different inert resins. The first inert resin (B) advantageously is different from the second inert resin (C). Preferably the inert resins (B) and (C) are of a different type.

In particular there is provided a radiation curable composition comprising at least one ethylenically unsaturated compound (A); at least one inert polyester resin (B); and at least one inert resin (C) different from (B). These compositions are particularly suited as binder compositions that are useful as ink vehicle.

By an "inert resin" is meant a resin that does not take part in the polymerization process. Such resins contain few or no curable reactive groups. "Curable reactive groups" are those capable of participating in the cure reaction that takes place when the radiation curable composition of the present invention is exposed to energy radiation, such as UV radiation, electron beam and/or actinic radiation. Due to imperfections in manufacture or to degradation on storage, resins that are considered essentially free of reactive groups may actually have a small number of reactive groups. Preferred are resins with 0.1 or fewer equivalents of curable reactive groups per kilogram; more preferred is 0.01 or fewer; even more preferred is 0.003 or fewer; still more preferred is 0.001 or fewer, and most preferred is none.

Some common reactive groups that are used in radiation curable compositions are double bonds in the form of e.g. (meth)acrylic groups and/or vinyl groups. Consequently, resins containing (meth)acrylic and/or vinyl groups in large amounts do not qualify as inert resins in the present invention. However, double bonds contained in aromatic rings are known to generally be inert during radiation curing. By "(meth)acrylic groups" is meant acrylic groups, methacrylic groups, and mixtures thereof.

Inert resins are well known in the art and have been described in e.g. WO2002/38688, WO2005/085369, W02008/015474, WO2008/004002, EP1411077 & US5919834.

Inert polyesters (B) that are used in the present invention can be produced in any way known in the art. They typically are prepared from the polycondensation of at least one polyol with at least one polycarboxylic acid and, optionally, from one or more monocarboxylic or monohydroxy compounds (see X1 and X2 infra). Typically, the polyols and the polycarboxylic acids used are saturated compounds, though some aromatic substructures may be present (see above). "Polyols" are compounds with two or more hydroxyl groups on each molecule. Preferred polyols are diols (i.e., polyols with two hydroxyl groups per molecule). A preferred diol is ethylene glycol (also known as ethane-1,2- diol).

Besides ethylene glycol, the polyol component used to prepare the polyester may, optionally, also comprise one or more other suitable polyols. By "other polyols" is meant a polyol different from ethylene glycol.

In an embodiment of the invention the polyol component used to prepare the polyester comprises ethylene glycol; and, optionally, one or more other suitable polyols. Preferably the polyol component used to prepare the polyester comprises from 10 to 100 mole% of ethylene glycol, and, optionally, from 0 to 90 mole% of other suitable polyols such as neopentyl glycol (2,2-Dimethyl-1,3-propanediol); diethylene glycol; propyleneglycol; dipropyleneglycol; triethyleneglycol; 2-methyl-1,3-propanediol (MPD), 2-ethyl-2-butyl-1,3-propanediol; 1-ethyl-2-methyl-1,3-propanediol; 2-ethyl-2-methyl-1,3-propanediol; 1,3-butylene glycol; 1,4-butanediol; 2,3-butanediol; 2-butyl-2-ethyl-1,3-propanediol (BEPD); pentanediol; 2-methyl 2-ethyl- 1,3-propane diol; 1,3-pentane diol; 2,2,4-trimethyl-1,3-pentane diol; hexyleneglycol; 1,6-hexanediol; 1,4-cyclohexanediol; 1,4-cyclohexanedimethanol; 3-hydroxy-2,2-dimethyl propyl-3-hydroxy-2,2-dimethyl-propanoate (hydroxylpivalyl hydroxypivalate (HPHP); hydroxypivalate of neopentyl glycol); 2,2,4-trimethyl-1,3-pentanediol (TMPD); hydrogenated Bisphenol A; a dianhydrohexitol (like isosorbide, isomannide and/or isoidide); 3(4),8(9)-bis-(hydroxymethyl)-tricyclo-[5.2.1.0^{2,6}]decane; and mixtures thereof (of any of these). Preferred amongst those "other suitable polyols" are neopentyl glycol; propyleneglycol; 2-methyl-1,3-propanediol (MPD); 2-ethyl, 2-butyl-1,3-propanediol; 1-ethyl-2-methyl-1,3-propanediol; 2-ethyl-2-methyl-1,3-propanediol; 1,3-butylene glycol; 1,4-butanediol; 2,3-butanediol; 2-butyl-2-ethyl-1,3-propanediol (BEPD); 2-methyl-2-ethyl-1,3-propane diol; 1,4-cyclohexanediol; 1,4-cyclohexanedimethanol; 3-hydroxy-2,2-dimethyl propyl 3-hydroxy-2,2-dimethyl-propanoate; hydrogenated Bisphenol A; a dianhydrohexitol (like isosorbide, isomannide and/or isoidide); and mixtures thereof. Most preferred are neopentyl glycol, hydrogenated Bisphenol A, and mixtures thereof; and in particular neopentyl glycol. Surprisingly, neopentyl glycol was found to improve adhesion on plastic substrates.

"Polycarboxylic acids" are compounds with two or more carboxylic acid groups on each molecule. Preferred polycarboxylic acids are diacids (i.e., polycarboxylic acids with two carboxylic acid groups per molecule).

In the practice of the present invention, the polycarboxylic acid may be an anhydride.

When inert polyesters (B) are prepared via transesterification, the polycarboxylic acid is substituted by a polycarboxylic acid dialkyl ester (like a phthalic acid dialkylester). In general the alkyl chains of this ester have from 1 to 20, preferably from 1 to 8, more preferably from 1 to 4 carbon atoms. Dimethylesters and/or diethylesters are usually preferred. Preferably however the inert polyester (B) is obtained via an esterificiation reaction.

In an embodiment of the invention the polycarboxy component used to prepare the polyester comprises phthalic acid and/or phthalic anhydride; and, optionally, one or more other suitable polycarboxylic acids. Typically the polycarboxy component comprises from 80 to 100 mole% of phthalic acid and/or phthalic anhydride; and, optionally, from 0 to 20 mole% of other suitable polycarboxylic acids. By "other polycarboxylic acids" is then meant polycarboxylic acids different from phthalic acid and from phthalic anhydride.

In a preferred embodiment of the invention the polycarboxy component comprises from 80 to 100 mole% of phthalic anhydride; and, optionally, from 0 to 20 mole% of other suitable polycarboxylic acids. By "other polycarboxylic acids" is then meant polycarboxylic acids different from phthalic anhydride.

Examples of "other suitable polycarboxylic acids" that may be used include chlorendic acid; chlorendic anhydride; adipic acid; oxalic acid; glutaric acid; malonic acid; butanedioic acid; glutaric acid; 1,4-cyclohexane dicarboxylic acid (CHDA); 1,4-cyclohexane dimethylcarboxylic acid; and mixtures thereof. Also terephthalic acid and/or isophthalic acid may be used. Particulary suited are: adipic acid; oxalic acid; glutaric acid; malonic acid; butanedioic acid; glutaric acid; 1,4-cyclohexane dicarboxylic acid; 1,4-cyclohexane dimethylcarboxylic acid; and mixtures thereof. Preferred are isophtalic acid; terephtalic acid; oxalic acid; malonic acid; and mixtures thereof. Also these compounds may be substituted by their corresponding dialkylester if the inert polyester (B) is prepared via transesterification, with dimethylesters and diethylesters being preferred.

Preferably, the other suitable polycarboxylic acids used to prepare the polyester contains less than 20 mole% of terephthalic acid and/or isophthalic acid, more preferably less than 15 mole% of terephthalic acid and/or isophthalic acid.

Though tri- and higher functionalized polycarboxylic compounds could in principle be used, they are less suited in the framework of the present invention.

Preferred are inert polyesters prepared from phthalic anhydride, from ethylene glycol and, optionally, from neopentyl glycol. These building units preferably constitute the polyol and polycarboxylic acid components used. Monocarboxylic compounds (X1) or monohydroxy compounds (X2) are optional further building units (see the polyesters B2 infra).

The one or more inert polyesters (B) used in the invention can be OH-terminated polyesters and/or can be COOH-terminated polyesters.

OH-terminated polyesters (B) are preferred. By an "OH-terminated polyester" in the present invention is meant an inert polyester prepared from mixtures of at least one polyol and at least one polycarboxylic acid as given above (any of the embodiments), wherein the total equivalent ratio ofhydroxyl groups from the polyols to carboxyl groups from the polycarboxylic acids exceeds 1.0. Preferred are mixtures wherein this ratio exceeds 1.02; more in particular exceeds 1.04. A molar excess of hydroxyl groups will result in polyesters that have free hydroxyl groups attached to the polymer backbone, in particular on the ends of the polymer backbone. By "free hydroxyl" is meant herein hydroxyl groups that have not reacted with carboxyl groups or other moieties to form new covalent bonds.

Preferred are those that have a hydroxyl number of between 50 and 120 mg KOH/g. Preferably the hydroxyl number is at least 60 mg KOH/g, more preferably at least 70mg KOH/g. Preferably the hydroxyl number does not exceed 110 mg KOH/g, more preferably does not exceed 100 mg KOH/g.

Preferably the acid number of these OH-terminated polyesters is at most 25 mg KOH/g, more preferably at most 15 mg KOH/g, more preferably at most 7 mg KOH/g.

By a "COOH-terminated polyester" (B) in the present invention is meant an inert polyester made from mixtures of at least one polyol and at least one polycarboxylic acid as given above (any of the embodiments), wherein the total equivalent ratio of carboxyl groups from the polycarboxylic acids to hydroxyl groups from the polyols exceeds 1.0. Preferred are mixtures wherein this ratio exceeds 1.02; more in particular exceeds 1.04. A molar excess of carboxyl groups will result in polyesters that have free carboxyl groups attached to the polymer backbone, in particular on the ends of the polymer backbone. By "free carboxyl" is meant herein carboxyl groups that have not reacted with hydroxyl groups or other moieties to form new covalent bonds.

Preferred are those that have an acid number of between 50 and 120 mg KOH/g. Preferably the acid number is at least 60 more preferably at least 70 mg KOH/g. Preferably the acid number does not exceed 110, more preferably does not exceed 100 mg KOH/g.

Preferably the hydroxyl number of these COOH-terminated polyesters is at most 25 mg KOH/g, more preferably at most 15 mg KOH/g, more preferably at most 7 mg KOH/g.

The above polyesters (OH- or COOH-terminated), optionally, can be capped or functionalized with one or more of monocarboxylic compounds (X1) and/or monohydroxy compounds (X2). According to a first variant of the invention the inert polyester is not capped or functionalized. The inert polyesters of this first variant are further referred to as the inert polyesters (B1). According to a second variant of the invention the inert polyesters are further reacted with these one or more of monocarboxylic and/or monohydroxy compounds (X1, X2). The resulting polyesters are further referred to as the inert polyesters (B2).

The inert polyester resins (B2) can be prepared in various ways. Either an inert OH- terminated polyester is first prepared, which is then further reacted with one or more monocarboxylic compounds (X1). Either an inert COOH- terminated polyester is first prepared, which is then further reacted with one or more monohydroxy compounds (X2). Either an inert COOH-terminated polyester is first prepared, which is then further reacted with one or more mono-epoxy compounds (X3). Alternatively, all ingredients are mixed to react in a one-pot system. An embodiment of this second variant relates to inert COOH-terminated polyesters that are further reacted with one or more monohydroxy compounds (X2) - also referred to as inert polyesters (B22) of the invention.

Preferably the amount of monohydroxy compounds (X2) used to prepare inert polyesters (B22) is calculated to obtain a theoretical acid value of less than 30 mg KOH/g, preferably less than 20 mg KOH/g and more preferably less than 10 mg KOH/g.

Examples of suitable monohydroxy compounds (X2) that can be used in this embodiment of the second variant are methanol; ethanol; isopropanol; n-propanol; sec-butanol; iso-butanol; n-butanol; tert-butanol; methyl-amyl alcohol; 2-methyl-1-butanol; cyclohexanol; or mixtures of any of these. Glycol ethers can also be used such as propylene glycol monomethyl ether, ethylene glycol monomethyl ether, propylene glycol t-butyl ether, ethylene glycol monopropyl ether, propyleneglycol monopropyl ether, propylene glycol isobutyl ether, propylene glycol monobutyl ether, ethylene glycol monobutyl ether, or mixtures of any of these.

Another and preferred embodiment of this second variant relates to inert OH-terminated polyesters that are further reacted with one or more monocarboxylic compounds (X1) - also referred to as inert polyesters (B21) of the invention.

Preferably the amount of monocarboxylic compounds (X1) used to prepare inert polyesters (B21) is calculated to obtain a theoretical hydroxyl value between 120 and 0 mg KOH/g. Preferably the residual hydroxyl value of the polyester (B21) is at most 115 mg KOH/g, more preferably at most 80 mg KOH/g. Most preferably the residual hydroxyl value is at most 50 mg KOH/g, more preferably at most 20 mg KOH/g. Particularly preferred are inert polyesters (B21) that have a residual hydroxyl number of between 5 and 80 mg KOH/g, more preferably of between 5 and 50 mg KOH/g.

By "residual" is meant herein a value for hydroxyl groups that remains after reaction with the one or more monocarboxylic compounds (X1).

Preferably the acid number of the inert polyesters (B21) is at most 25 mg KOH/g, more preferably at most 15 mg KOH/g, more preferably at most 7 mg KOH/g.

Examples of suitable monocarboxylic compounds (X1) that can be used are monocarboxy-substituted moieties having photo-initiating activity. Preferred are photo-initiators of the carboxylic substituted benzophenone-type. Examples of such compounds are 2-(4-chlorobenzoyl) benzoic acid (Chloro-AOBB), o-benzoylbenzoic acid (o-BBA), o-(p-dimethylaminobenzoyl) benzoic acid, o-(p-diethylaminobenzoyl) benzoic acid etc. as described in e.g. US4028204. Also suitable is 2-(4-Phenylbenzoyl)benzoic acid. Another example of a monocarboxylic compound without photo-initiating properties that can be used is benzoic acid and substituted benzoic acid, or any combination thereof. Examples of substituted benzoic acid include tert-butyl benzoic acid (such as 4-tert-Butylbenzoic acid, 3-tert-Butylbenzoic acid, or 2-tert-Butylbenzoic acid), naphthalene carboxylic acid, 4-dimethylaminobenzoic acid and any combinations thereof. Particularly suited are 2-(4-chlorobenzoyl) benzoic acid, o-benzoylbenzoic acid, 2-(4-Phenylbenzoyl)benzoic acid, benzoic acid, substituted benzoic acid, or any mixture thereof. Surprisingly it was found that both UV reactivity and adhesion improve therewith. According to a third variant of the invention, the composition of the invention comprises one or more inert polyesters (B1) according to the first variant and one or more inert polyesters (B2) according to the second variant. Polyesters (B1) preferably are OH-terminated. Polyesters (B2) preferably are prepared from such OH-terminated polyesters (B1).

Typically, based on the total weight of the inert polyesters (B), the weight percentage of inert polyesters (B1) of the first variant is between 0 and 100%, and the weight percentage of inert polyesters (B2) of the second variant is between 100 and 0%.

Inert polyesters (B) of the invention (according to any of the embodiments or variants) typically have a number average molecular weight (Mn) of between 500 and 5000 Daltons. Preferably the Mn is at least 500 Daltons, more preferably at least 750 Daltons. Preferably the Mn is at most 2500 Daltons, more preferably at most 2000 Daltons.

Inert polyesters (B) of the invention (according to any of the embodiments or variants) typically have a weight average molecular weight (Mw) of between 1000 and 10000 Daltons. Preferably the Mw is at least 1200 Daltons, more preferably at least 1500 Daltons. Preferably the Mw is at most 3500 Daltons, more preferably at most 3000 Daltons.

Molecular weights (Mn or Mw) typically are determined via gel permeation chromatography (GPC), typically using polystyrene standards. Most typically the Mn and Mw are measured by GPC (in a tetrahydrofuran (THF) solution, and injected on a 3xPLgel 5 µm Mixed-D LS 300x7.5mm column MW - range 162 to 377400 g/mol & calibrated with polystyrene standards (200-400.000 g/mol), at 40 °C).

Inert polyesters (B) of the invention (according to any of the embodiments or variants) typically have a glass transition temperature (Tg) of at least 5 °C, preferably at least 10°C, more preferably at least 15 °C. Generally the Tg is at most 120°C, preferably at most 80 °C, more preferably at most 40 °C, as measured by dynamic scanning calorimetry e.g. according to ASTM E 1356-08 with heating gradient of 10 degrees C per minute.

Based on the total amount of (A), (B) and (C), the amount of inert resins (B) in general is between 20 and 80% by weight (wt%). More typically this percentage is at least 30%, more preferably at least 40 % by weight. Generally their amount does not exceed 65%, more preferably it does not exceed 55% by weight.

The at least one inert resin (C) in general is selected from acrylic resins (more in particular polyacrylics), polystyrene resins, (poly)urethane resins, polyethylenevinyl acetate resins, polyvinylchloride resins, styrene allyl alcohol resins, chlorinated polyolefin resins and/or ketone resins. Preferred are polystyrene resins, acrylic resins and/or ketone resins. Most preferred are polystyrene resins and/or acrylic resins.

Examples of suitable ketone resins are for instance the ketone resins based on acetophenone-formaldehyde as described in e.g. W02005/085369. Particularly suited is VARIPLUS AP available from Evonik. Ketone resins are typically put in dilution in monomers at higher temperatures (typically from 60-80°C). Ketone resins are somewhat less preferred in the present invention because of their smell.

Acrylic resins suitable for use in the present invention are also well known in the art and have been described in e.g. W02008/004002. Preferred are in particular full acrylic resins like Ebecryl 764 available from Cytec.

Polystyrene resins are most preferred. Suitable polystyrene resins are also well known in the art. Polystyrene resins used preferably have a number average molecular weight (Mn) of between 100 and 5000 Daltons. Preferably the Mn is at least 200 Daltons, more preferably at least 250 Daltons. Preferably the Mn is at most 2500 Daltons, more preferably at most 1500 Daltons.

In general polystyrene resins used have a weight average molecular weight (Mw) of between 1000 and 10000 Daltons. Preferably the Mw is at least 500 Daltons, more preferably at least 1000 Daltons. Preferably the Mw is at most 5000 Daltons, more preferably at most 2500 Daltons.

A typical example of polystyrene resins that may be used are e.g. the PICCOLASTIC™ polystyrene resins available from Eastman. Particularly suited are PICCOLASTIC™ A75 (Mn 808; Mw 1796) and NL 85 (Mn 262; Mw 1277).

Based on the total amount of (A), (B) and (C), the amount of inert resins (C) in general is between 10 and 40% by weight. More typically this percentage is at least 15%, more preferably at least 20%. Generally their amount does not exceed 35%, more preferably it does not exceed 30% by weight.

Based on the total amount of (A), (B) and (C), the total amount of inert resins (B) and (C) in general is between 20 and 80% by weight. More typically this percentage is at least 30%, more preferably at least 40%. Generally their amount does not exceed 75%, more preferably it does not exceed 55% by weight.

In general the (binder) composition of the invention comprises from 20 to 80 %, by weight, of compound (A) and from 80 to 20 %, by weight, of inert resins (B) and (C). More in particular the (binder) composition of the invention comprises from 40 to 60 %, by weight, of compounds (A) and from 60 to 40 %, by weight, of inert resins (B) and (C).

In general the ethylenically unsaturated compound (A) comprises at least one (meth)acrylated compound. By "(meth)acrylated" is meant acrylated, methacrylated, or mixtures thereof. Preferably compounds (A) are acrylated compounds. The (meth)acrylated compounds used in the present invention can be in the form of monomers, oligomers or mixtures thereof. Preferred are those that are liquid at room temperature. Some examples of suitable compounds are given below.

Examples of (meth)acrylated oligomers (Ai) that can be used in the present invention include amino (meth)acrylate oligomers, polyester (meth)acrylates, (poly)urethane (meth)acrylates and epoxy (meth)acrylates. Once more the acrylated forms are preferred. Preferably the composition of the invention however comprises no (meth)acrylated oligomers.

Monomers used can be mono- and/or poly-functional (meth)acrylates (Aii). Particularly suited for use in the present invention are cardura (meth)acrylate (the (meth)acrylate of the glycidyl ester of neodecanoic acid also known as Cardura®E-10P), 3(4),8(9)-bis-(hydroxymethyl)-tricyclo-[5.2.1.0^{2,6}]decane di(meth)acrylate, 1,6-hexanediol di(meth)acrylate, dipropyleneglycol di(meth)acrylate, tripropyleneglycol di(meth)acrylate and/or trimethylolpropane tri(meth)acrylate. Especially the acrylated forms thereof are used. The inert resins ((B) and optionally (C)) typically are soluble in such diluting (meth)acrylate monomers in at least 20 wt%, more preferably at least 30 wt %.

Preferred diluting monomers (Aii) are di(meth)acrylates and/or tri(meth)acrylates like 1,6-hexanediol di(meth)acrylate , dipropyleneglycol di(meth)acrylate, 3(4),8(9)-bis-(hydroxymethyl)-tricyclo-[5.2.1.0^{2,6}]decane di(meth)acrylate, tripropyleneglycol di(meth)acrylate and/or trimethylolpropane tri(meth)acrylate. Most preferred are di(meth)acrylates, more in particular diacrylates, and in particular dipropyleneglycol diacrylate (DPGDA) and/or tripropyleneglycol diacrylate (TPGDA).

Mono-functional and/or tetra-functional (meth)acrylates can be used, but preferably they are used in an amount lower than 40% by weight, more preferably less than 20% by weight, based on the total amount of mono- and poly-functional monomers (Aii).

Preferably the ethylenically unsaturated compound (Aii) is for at least 80 wt% comprised of difunctional (meth)acrylates and/or tri(meth)acrylates, and for at most 20 wt% of mono-functional (meth)acrylates and/or tetra-functional (meth)acrylates. Most preferably the (meth)acrylated compound (Aii) contains no mono-functional (meth)acrylates.

The above diluting monomers (Aii) can, optionally, be further reacted with an amine to form an amino (meth)acrylate (Aiii) having residual free (meth)acrylate groups. By "residual free" is meant (meth)acrylate groups that remain after reaction with the amines. Preferred are amino (meth)acrylates with two or three (meth)acrylate groups per molecule after reaction with the amines. The (meth)acrylate group preferably is an acrylate group.

The amines used in this reaction are generally selected from primary amines and secondary amines. Generally preferred are primary amines comprising at least one primary amino group (-NH2) and/or secondary amines comprising at least two secondary amino groups (-NH) as described in WO 2008/000696 - see compounds A1&A2 therein. Process conditions as described therein can also be used here.

Amino (meth)acrylates (Aiii) can be added as such to the composition of the invention but may also be formed in situ by introducing the amine to the blend of inert polyesters ((B) and optionally (C)) and (meth)acrylated compounds (Aii), maintaining the reaction temperature typically at 60°C until the reaction is finished. The completion of the reaction can be followed for example by measuring the amount of free amine. The completion of the reaction can be followed for example by measuring the amount of free amine. For instance, amine contents can be determined by reacting quantatively the amines with CS2. The resulting thiocarbamic acid is potentiometrically titrated with NaOH. The amine content value is expressed in ppm. Examples of suitable amino (meth)acrylates (Aiii) include EBECRYL 7100, EBECRYL 80, EBECRYL 81, EBECRYL 83, EBECRYL 84, EBECRYL LEO 10551, EBECRYL LEO 10552 & EBECRYL LEO 10553, all available from Cytec.

The composition of the invention can, optionally, further comprise amine derivatives (D) obtained from the reaction between diluting monomers (Aii) as described above and amines, wherein the amine derivative obtained contains no residual free (meth)acrylate groups. Typically secondary amines A2 such as described in WO 2008/000696 are used in this reaction. Examples of suitable amine derivatives (D) are EBECRYL P115 and EBECRYL P116, available from Cytec.

Amino (meth)acrylates (Aiii) and amine derivatives (D) can act as photoactivators and enhance cure speed in the presence of type II photoinitiators, and benzophenone derivatives in particular.

Based on the total amount of compounds (A), (B) and optionally (C), the total amount of ethylenically unsaturated compounds (A) in general is between 15 and 85% by weight. More typically this percentage is at least 25%, more preferably at least 35 %. Generally their amount does not exceed 75%, more preferably it does not exceed 65 % by weight.

Typically, on the total amount of compounds (A) the amount of diluting monomers (Aii plus Aiii) is between 20 and 100 % by weight. More typically this percentage is at least 50%, more preferably at least 80 %, generally it is 100%.

The optional amine derivatives (D) can replace up to 50 % by weight, typically up to 25% by weight of the total amount of ethylenically unsaturated compounds (A). When present, the amine derivatives (D) typically are used in an amount from 0.01 to 25% by weight, in general from 5 to 20% by weight, based on the total weight of the composition.

Viscosity of the binder, more in particular the blend composed of compounds (A), (B) and (C), typically ranges from 100 to 10000 mPa.s at 25°C. Preferably the viscosity ranges from 200 to 5000 mPa.s. More preferably the viscosity ranges from 500 to 3000 mPa.s as measured using a cone and plate type rheometer with a cone diameter of 25 mm and at an angle of 1° for the cone. The compositions according to the invention can be prepared by any method suitable therefore. They are usually prepared by dissolving the inert resins (B) and in (C) in at least part of the (meth)acrylated compounds (A) added, preferably at a temperature of at least 20 °C, more preferably of at least 30 °C, most preferably of at least 60 °C. The temperature preferably does not exceed 150 °C, more preferably it does not exceed 110 °C. The compositions according to the invention can be prepared in the presence of an organic solvent, which is thereafter eliminated from the composition, for example by stripping. Other ingredients can be added to the composition. More preferably, no solvents are used.

Other compounds can be added like pigments, dispersing agents or other additives, charges and photoinitiator. Often a photoinitiator and, optionally, a photoactivator are added.

Generally, the composition of the present invention comprises at least 10% by weight, more preferably at least 15% by weight and most preferably at least 20% by weight of ethylenically unsaturated compounds (A), based on the total weight of the composition. The amount of such compounds (A) in the composition usually does not exceed 85% by weight, preferably does not exceed 75% and more preferably does not exceed 65% by weight.

Generally, the composition of the present invention comprises at least 20% by weight, more preferably at least 30% by weight and most preferably at least 40% by weight of the inert resins (B) and (C), based on the total weight of the composition. The amount of inert resins (B) and (C) in the composition usually does not exceed 75% by weight, preferably does not exceed 65% by weight, and more preferably does not exceed 55% by weight.

Typically the compositions of the invention comprise, based on the total weight of (A), (B) and (C), between 15 and 85% by weight of the compounds (A) and between 85 and 15% by weight of inert polyesters (B) and (C).

An aspect of the invention relates to coating composition, ink or varnishes comprising a composition, more in particular a binder composition according to the invention.

The compositions according to the invention after curing permit to obtain excellent adhesion on various organic and inorganic substrates such as plastic, metal, glass, wood, paper, in combination with high cure speed and low viscosity. In particular adhesion on plastic substrates like polypropylene, bioriented polypropylene, polyethyelene, polyvinylchloride, polyester and polyamide films. Plastics can be of any type, e.g. the woven or non-woven type, can be porous or permeable etc. The plastic can be rigid but preferably is flexible.

An advantage of the compositions of the invention is that they permit to obtain good adhesion on e.g. plastics without the need of an adhesion primer. The possibility to graft functional groups on the polyester resin (B) can further improve adhesion and reactivity.

Pigment wetting is excellent which makes the compositions of the invention useful as ink vehicle for the preparation of inks, in particular inks for lithographic and flexographic applications. The compositions of the invention are particularly suited for printing onto a wide variety of rigid and flexible graphics, packaging and label substrates, as well as most plastics, glass and metal foil. The compositions of the invention are very suited for gravure, flexographic and lithographic applications. They are most suited as flexo inks for narrow, mid and wide web applications.

The composition of the present invention is therefore useful as ink vehicle for the preparation of inks. Typical ingredients used in the preparation of inks (paste or liquid) may thus be added. These compounds are generally selected from organic and inorganic pigments, photoinitiators, fillers and additives.

The pigments usable in the compositions of the invention are every pigments used in paste inks or liquid inks. A list of such pigments can be found in the Color Index. The pigments are preferably used at 0 to 60 % by weight of the total weight of the composition, more preferably at 1 to 50 % by weight.

The photoinitiators usable in the compositions of the invention are well known in the art. They can be chosen from α-hydroxyketones, α-aminoketones, benzildimethyl-ketals, acyl phosphines, benzophenone derivatives, thioxanthones and blends of these. They are used at 0 to 15% by weight. Generally, photoactivators are chosen between amine derivatives (D) and amino(meth)acrylates (Aiii) as discussed above such as EBECRYL P115, EBECRYL P116, EBECRYL 7100, EBECRYL 80, EBECRYL 81, EBECRYL 83, EBECRYL 84, EBECRYL LEO 10551, EBECRYL LEO 10552 & EBECRYL LEO 10553, all available from Cytec. In general photoinitiators and possibly also photoactivators are added if the compositions are cured by ultraviolet light. The compositions may however also be cured by electron beams rays, and, in this case, no photoinitiator and photoactivator needs to be added to the composition. In addition, advantageously no photoiniator needs to be added to the composition when a moiety with photoinitiating activity, more in particular a benzophenone derivative, is grafted onto the inert polyester of the invention (see inert polyesters B2 above). In such case, it may be advantageous to add photoactivators to the composition.

The additives are those commonly used in inks, such as stabilizers, substrate wetting agents, antifoam agents, dispersing agents, etc. The total amount of those additives does usually not exceed 10%.

As fillers products such as calciumcarbonate, talc (magnesium silicate), kaolin clay (aluminium silicate), bariumsulphate, aluminium hydroxide, siliciumdioxide can be used. The amount of fillers is generally from 0 to 15% by weight of the total weight of the composition.

The composition according to the invention comprises, based on the total weight of the composition, from 20 to 70% by weight of the binder (composed of compounds (A), (B) and (C)), from 0 to 50% by weight of pigments, and from 0 to 50% by weight of one or more usual ingredients selected from additives, fillers, photoinitiators and the like. Typically the compositions of the invention comprise, based on the total weight of the composition, at least 20% by weight of the binder, often at least 40% by weight of binder.

An aspect of the invention relates to coating compositions and in particular inks and varnishes that comprise the binder composition as described above. Provided are inks and varnishes that are prepared from the binder compositions of the invention. The invention also relates to a process for the preparation of inks, in particular flexographic, litho inks and screen inks, wherein a binder composition according to the invention is used. More preferably, this invention relates to a process for the preparation of flexographic inks.

Flexographic inks are generally made in 2 steps, the pigment dispersion step and the letdown step. The composition according to the invention can be used in one or both of these steps. The composition according to the invention is preferably used as binder at least in the first step. In the first step, the pigments and optionally a photoinitiator, fillers and/or additives are added to at least part of the composition comprising the resin (B), the resin (C) and (meth)acrylated compound (A). They are mixed and then dispersed on a triple roll or bead mill. A few passes might be necessary to achieve a good dispersion. Pigments that are difficult to disperse generally require more number of passes. The compositions according to the invention showing good pigment wetting, permit to limit the number of additional passes. Once the pigment has achieved this fineness, the pigment paste is further diluted with the letdown. This letdown is preferably composed of the same resin components (A), (B) and (C). The letdown has to be compatible with the binder used to disperse the pigments.

The finished ink preferably has a viscosity higher than 300 mPa.s measured at a shear rate of 2500 s-1 at 25 °C (measured using a cone and plate type rheometer with a cone diameter of 25 mm and at an angle of 1° for the cone). The measurement is generally done by measuring a flow curve in controlled shear rate ranging from D = 0.1 s-1 to D = 2500 s-1 at 25 °C.

The finished ink preferably has a viscosity measured as here above of at least 500 mPa.s. The viscosity of the final generally does not exceed 8000 mPa.s, preferably it does not exceed 4000 mPa.s (at 25 °C and 2500 s-1).

The finished ink is then printed onto the substrate. The ink film can then be cured under a UV lamp, for example at 120W/cm and 50 m/min. A few passes may be required to cure the ink if the binder is not reactive enough.

The invention also relates to the polymeric compositions obtainable by curing the radiation curable composition as well as to substrates or articles being partially or entirely coated with the polymeric composition.

Finally, the invention relates to a process for coating an article or a substrate comprising the step of applying onto at least one surface of said article or of said substrate the composition of the invention, following by curing of the applied layer. The composition of the invention can be directly applied onto said substrate or said article without the need of an adhesion primer. A physical treatment (e.g. corona) and/or chemical treatment before applying the radiation curable composition is preferred in some cases. The composition of the invention can be applied in one or more layers of between 0.5 and 10 µm by means of flexographic process, lithographic process, gravure, screen printing, letterpress, roller coater, curtain coater. Preferably, it is applied by flexographic process. The material or surface to be coated can comprise plastic, in particular can be made of plastic, including a non polar plastic. The plastic can be flexible or rigid.

A final aspect of the invention relates to inert polyester resins (B22) as described above, and to radiation curable composition comprising at least one ethylenically unsaturated compound (A); at least one inert polyester resin (B22); and preferably also at least one inert resin (C) different from (B22). Examples of suitable compounds (A), (B22) and (C) have been described above.

Throughout the invention and in particular in the Examples the following methods have been used to characterize the compositions of the invention:

Acid value: total acid number (IAc in mg KOH/g) were measured using potentiometric titration. The "total acid number" equals the milligrams of potassium hydroxide (KOH) required to neutralize the acid(s) present in 1g of sample after hydrolysis of present anhydrides. The anhydrides present in the sample are hydrolysed to the corresponding acids during a hydrolysis step and titrated with a standardized solution of KOH. Different titrant solutions i.e. KOH 0.1N and / or KOH 0.5N can be used when analyzing samples with low respectively high total acid number. Potentiometric titration allows end-point identification automatically by means of a titroprocessor and a pH electrode, the manual titration uses a color indicator (phenolphthalein) for visual end-point identification. The amount of KOH is used to calculate the total acid number.

Hydroxyl values (IOH in mg KOH/g) were measured using the following method. This "OH Number" method covers the automated quantification procedure for hydroxyl groups in polyester resins by means of potentiometric titration. The hydroxyl number is defined as the number of milligrams of potassium hydroxide required to neutralize the hydrolysis product of the fully acetylated derivative prepared out of one gram of polyester resin. Step 1 Acetylation step: All hydroxyl functions on the polyester resin are acetylated at room temperature by acetic anhydride in the presence of perchloric acid as catalyst. Dichloromethane (= methylenechloride CH2C12) functions as solvent. Step 2 Hydrolysis step: The excess of acetic anhydride is hydrolysed by means of water, N-methyl-2-pyrrolidone (NMP) functions as co solvent to dissolve water in methylene chloride and N-methylimidazole (NMI) functions as hydrolysis catalyst. Step 3 Titration step: The formed acid functions are titrated with KOH 0.5 N solution.

UV reactivity: a film of 1.2µm is applied on the tested BOPP (bioriented polypropylene), PET (polyethyleneterephtalate), polyester substrates without adhesion primer but with corona treatment and exposed to UV radiations from a 120 W/cm non focalized medium pressure mercury lamp at a defined conveyer speed (60 m/min) under air. For yellow, magenta and cyan inks: the fully cured aspect of the film is assessed by putting some graphite carbon black (Pensil Nr 2) onto the printed surface and rubbing with a finger and then with a cotton swab. As long as a black trace is left on the printed ink surface, the film is not fully cured and passed again under the UV-lamp. This is the so-called "graphite test". For black inks: the fully cured aspect of the film is assessed by putting some talc onto the printed surface and rubbing with a finger and then with a cotton. As long as a mat aspect is observed, the film is not fully cured. In both cases one assesses the number of times that the film has to pass at 60 m/min to obtain full curing (x passes at 60 m/min). The lower "x" is, the higher the cure speed.

Adhesion: a film of 1.2µm is applied on the tested substrate and exposed to UV radiations from a 120W/cm non focalized medium pressure mercury lamp at a speed of 60 m/min and fully cured as described in the reactivity method. A string of adhesive tape (Tesa 4104) is pressed on the surface and the interlayer is degassed. The tape is then snatched off. Based on the % of the surface removed by the tape, a value of adhesion is given: 0 (100% of the squares removed), 1 (65-35% of the squares removed), 2 (35-15% of the squares removed), 3 (15-5% of the square removed), 4 (less than 5% of the squares removed, 5 (0%).

Pigment wetting properties of the resin is evaluated during different stages: during pigment paste preparation stage and after curing.

During pigment paste preparation phase the pigment wetting is evaluated in the following way: For the present invention the pigment wetting is rated on a scale from 5 = excellent to 0 = bad pigment wetting. To assess pigment wetting the weight of the binder (blend of compounds (A), (B) and optionally (C)) and of the pigment that will be put on top of the binder are first determined, and then both are mixed by hand. Then the easiness of mixing (wetting) the pigment with the binder is determined. When a homogeneous paste is obtained, it is grinded on a three roller mill (2x at 12 bar) and the behavior on the rolls is being checked. In case of a bad pigment wetting, dry pigment can be found on the rolls. The dispersion rate on the grinding gauge is checked as confirmation of bad wetting. With the grinding gauge the thickness of the pigment particles is measured. The smaller the size of the particles, the better is the pigment wetting. The high gloss of the paste on the rolls is also an indication of good pigment wetting.

Pigment wetting after curing is evaluated by measuring the optical density (after this step). Optical density: The color density of the printed ink at constant film thickness is measured. In this case the ink is printed using a lab applicator and the color density is measured with a densitometer, which spectrophotometrically compares the reflected light to the incident light. Here, a Gretag Macbeth Spectroeye Spectrophotometer / Densitometer equipped with the appropriate filters was used to measure optical density. Film thickness (in g/m²) is determined by comparing the weight of the printed form or substrate before and after printing.

Rheology (yield value, viscosity, shortness index): is measured using a cone and plate type rheometer MCR100 (Paar-Physica) following ISO 3219. The measurement geometry for measuring the (flexo) inks of the inventions was of a diameter of 25mm and an angle of 1° for the cone. The measurement was a flow curve in controlled shear rate ranging from D = 0 s-1 (zero viscosity), D = 2.5 s-1 to D = 2500 s-1 at 25 °C.

Viscosity of the resin: is measured at a fixed shear rate with a cone and plate type rheometer MCR100 (Paar-Physica).Transition temperatures (Tg) were measured by DSC following ASTM E1356-08.

Molecular weight distribution was measured by gel permeation chromatography (GPC). It was determined with 3 x PLgel 5µm Mixed-D LS 300 x 7.5mm separation columns, polystyrenes calibration (MW range : 200 - 400.000 Daltons), TetrahydroFuran (THF) as solvent and Refractive Index as detector.

The invention will now be illustrated by the following non-limiting examples which are by way of illustration only. Unless otherwise indicated, all the test results and properties herein were performed using conventional methods well known to those skilled in the art. The amounts in the tables are given in % by weight based on the total weight of the composition.

### Preparative examples:

### Example 1: OH-terminated polyester based on EG and PA

A 5 liter reactor equipped with a stirrer and a column is charged with 343 g of ethylene glycol (EG), 722 g of phthalic anhydride (PA), and 750 ppm of a tin catalyst. The mass is heated to 190°C under atmospheric pressure and nitrogen flow. After 70% of the water is distillated, the temperature is increased up to 220°C in the mass, after which vacuum is applied. The reaction mixture is heated until the acid value is lower than 10 mg KOH and the hydroxyl value reaches 65-80 mg KOH/g. Mn = 1480; Mw = 2720 as measured by GPC.

### Example 2: Polyester based on EG and PA modified with 2-(4-chlorobenzoyl) benzoic acid

1494 g of the polyester from example 1 is further reacted with 464 g of 2-(4-chlorobenzoyl) benzoic acid until both the acid and hydroxyl values are lower than 10 mg KOH/g.

### Example 3: OH-terminated polyester based on EG and PA

A similar process as in Example 1 is used, but 983 g of ethyleneglycol and 2022 g of phthalic anhydride are charged. The reaction mixture is heated until the acid value is lower than 10 mg KOH/ and the hydroxyl value reaches 80 mg KOH/g.

### Example 4: OH-terminated polyester based on EG, PA and NPG

A similar process as in Example 1 is used, but 828 g of ethyleneglycol, 2022 g of phthalic anhydride and 261 g of neopentylglycol (NPG) are charged. The reaction mixture is heated until the acid value is lower than 10 mg KOH/ and the hydroxyl value reaches 90 mg KOH/g.

### Example 5: COOH-terminated polyester based on EG, PA and NPG

A similar process as in Example 1 is used, but 134 g of ethyleneglycol , 400 g of phthalic anhydride and 42 g of neopentylglycol are charged. The reaction mixture is heated until the acid value reaches 14-28 mg KOH/ and the hydroxyl value is lower than 35 mg KOH/g.

### Formulation examples:

Binder compositions were prepared by dissolving the inert resins (B) and/or (C) at 70 to 90 °C in the acrylated compounds (A) according to the ratios (in g) as indicated in the Table 1 below. Viscosity of the resin was determined at a shear rate of zero, 2.5 and 2500 s-1 at 25°C as indicated above. Binders B1-B4 are compositions according to the invention, whereas B5R-B7R compositions constitute comparative Examples.

The pigment paste was prepared as follows. 66 wt % of the binder was mixed with 30 wt % of pigments and 4 wt % of additives. The paste was grinded on triple rolls until the right grinding gauge was obtained.

The ink was prepared from this pigment paste by diluting further with the resin binder, photoinitiator and diluting monomers to achieve the target viscosity.

The pigment paste was prepared as follows: 66 wt % of the binder was mixed with 30 wt % of pigments and 4 wt % of additives. In particular 65.7 g of the binder was blended at 25 °C with 1 g of ADDITOL® S120 (a stabilizer blend from Cytec), 2.5 g of SOLSPERSE® 39000 (a 100% active polymeric dispersant from Lubrizol), 0.8 g of SOLSPERSE® 5000 (a 100% active pigmentary synergist from Lubrizol) and 30 g of GLO pigment (Copper Phthalocyanine - Irgalite GLO of Ciba).

The paste was grinded on triple rolls until the right grinding gauge was obtained.

The ink was prepared from this pigment paste by diluting further with the resin binder, photoinitiator and diluting monomers to achieve the target viscosity. In particular cyan inks (at 14% pigment) were prepared by blending at 25 °C 43 g of the binder with 10 g of a photoinitiator mix (composition: 30% ITX (isopropylthioxanthone); 25% Additol EPD from Cytec; 25% Additol EHA from Cytec; 5% Additol PBZ from Cytec; 15% Irgacure 369 from BASF) and 47 g of the Pigment paste at 30%.

Various properties of the obtained ink formulations were measured. Formulations in question are I1 to 14,15-R and 17-R respectively.

Ink viscosity is considered as good when the viscosity at a shear rate of 2500 s-1 and at 25°C is ≤ 2500 mPa.s for the formulations as tested. UV reactivity is considered as particularly good when ≤ 2x 60 m/min, UV reactivity is considered as acceptable when ≤ 3x 60 m/min. Adhesion in one and two layers is considered as particularly good when ≥ 4 at 1x30 m/min. Pigment wetting is considered as particularly good when the optical density is > 1.3.

Table 2 shows that the compositions according to the present invention permit to obtain inks having excellent adhesion on plastics - even when 2 ink layers were applied - and this without the need for an adhesion primer. This is combined with an acceptable cure speed, good pigment wetting and suitable viscosity ranges. In comparison, inks based on a polystyrene resin only (Formulation Examples P7-R & I7-R) have lower pigment wetting properties which result in more difficulties during the pigment grinding. If the ink is based on an inert polyester resin only, then adhesion in two layers is less good (Formulation Examples P5-R & 15-R). In conclusion: the overall balance of properties improves when using compositions according to the invention.

Further pigment paste and ink formulations were prepared with the compositions and comparative compositions from Table 3, wherein the polystyrene resin was replaced by a ketone or an acrylic resin. Various properties of the obtained pigment paste and ink formulations were measured and the results are summarized in Tables 4A and 4B. Formulations in questions are P1-P2 & P3-R and IN1-IN2 & IN3-R respectively.

Table 4 again shows that the overall balance of properties is good for compositions according to the invention. No good results were obtained with an ink based on a ketone resin only (compared to results obtained with IN1). Combination of a polyester resin with a full acrylic resin resulted in a better pigment wetting in combination with good adhesion.

**Table 1: Evaluation of the binder compositions**

| Binder | B1 | B2 | B3 | B4 | B5-R | B6-R | B7-R |
|---|---|---|---|---|---|---|---|
| Inert resin B | Ex3 | Ex2 | Ex4 | Ex5 | Ex3 | Ex4 | - |
| Inert resin C | Polystyrene* | Polystyrene | Polystyrene | Polystyrene | Polystyrene | - | Polystyrene |
| Diluent A | DPGDA | DPGDA | DPGDA | DPGDA | DPGDA | TPGDA | DPGDA |
| Weight ratio | 25/25/50 | 25/25/50 | 25/25/50 | 25/25/50 | 50/50 | 50/50 | 50/50 |
| Viscosity (mPa.s) | 550 | 950 | 1090 | 1140 | 1250 | 3030 | 700 |
| Resin type | Polyester/ Polystyrene | Polyester/ Polystyrene | Polyester/ Polystyrene | Polyester/ Polystyrene | Polyester | Polyester | Polystyrene |

| | | | | | | | |
|---|---|---|---|---|---|---|---|
| * the polystyrene used is PICCOLASTIC™ hydrocarbon resin of the type A75from Eastman with a Mw of 1300 | | | | | | | |

**Table 2: Evaluation of the radiation curable inks**

| Table 2B | | | | | | | | | | | | |
|---|---|---|---|---|---|---|---|---|---|---|---|---|
| Formulation | 11 | | 12 | | 13 | | 14 | | 15-R | | 17-R | |
| Binder | B1 | | B2 | | B3 | | B4 | | B5-R | | B7-R | |
| | Polyester/ | | Polyester/ | | Polyester/ | | Polyester/ | | | | | |
| Resin type | Polystyrene | | Polystyrene | | Polystyrene | | Polystyrene | | Polyester | | Polystyrene | |
| Viscosity of the cyan ink at 14% pigment (mPa.s) | | | | | | | | | | | | |
| Zero visco | 49200 | | 7370 | | 23800 | | 376000 | | 151000 | | 2750 | |
| 2.5 s-1 | 6180 | | 3700 | | 6020 | | 10800 | | 6830 | | 2030 | |
| 2500 s-1 | 919 | | 1320 | | 1700 | | 2180 | | 1660 | | 991 | |
| Adhesion on uncoated BOPP (+ corona) | | | | | | | | | | | | |
| at various cure speeds | L1 | L2 | L1 | L2 | L1 | L2 | L1 | L2 | L1 | L2 | L1 | L2 |
| 1 x 30 | 5 | 4 | 5 | 5 | 5 | 5 | 5 | 5 | 5 | 2 | 5 | 5 |
| 2 x 30 | 5 | 4 | 5 | 5 | 5 | 5 | 5 | 5 | 5 | 2 | 5 | 5 |
| 3 x 30 | 5 | 4 | 5 | 5 | 5 | 5 | 5 | 5 | 5 | 4 | 5 | 5 |
| 4 x 30 | 5 | 5 | 5 | 5 | 5 | 5 | 5 | 5 | 5 | 4 | 5 | 5 |
| 6 x 30 | 5 | 5 | 5 | 5 | 5 | 5 | 5 | 5 | 5 | 5 | 5 | 5 |
| Reactivity C58 at 60m/min | 3x | | 2x | | 3x | | 2x | | 3x | | 2x | |
| Density | 1.5 | | 1.6 | | 1.45 | | 1.3 | | 1.52 | | 1.59 | |
| Effect on the roll | Ok | | Ok | | Ok | | Worse | | Good | | Worse | |

**Table 3: Evaluation of the binder compositions**

| Binder | B8 | B9 | B10-R |
|---|---|---|---|
| Inert resin B | Ex3 | Ex3 | - |
| Inert resin C | Ketone resin* | Acrylic* | Acrylic** |
| Diluent A | DPGDA | DPGDA | DPGDA |
| Weight ratio | 25/25/50 | 25/40/35 | 50/50 |
| Viscosity (mPa.s) | 1220 | 1780 | 700... |
| Resin type | Polyester/ | Polyester/ | |
| | Ketone | Acrylic | Acrylic |

| | | | |
|---|---|---|---|
| * the ketone resin is VARIPLUS AP available from Evonik ** the Ebecryl 764 acrylic resin is a full acrylic resin available from Cytec | | | |

**Table 4: Evaluation of the radiation curable inks**

| Table 4B | | | | | | |
|---|---|---|---|---|---|---|
| Formulation | IN1 | | IN2 | | IN3-R | |
| Binder | B8 | | B9 | | B10-R | |
| | Polyester/ | | Polyester/ | | | |
| Resin type | Ketone* | | Acrylic** | | Acrylic | |
| Viscosity of the cyan ink at 14% pigment (mPa.s) | | | | | | |
| Zero visco | 7700 | | 199000 | | 2100000 | |
| 2.5 s-1 | 4450 | | 22400 | | 53500 | |
| 2500 s-1 | 1590 | | 2610 | | 1603 | |
| Adhesion on uncoated BOPP (+ corona) | | | | | | |
| at various cure speeds | L1 | L2 | L1 | L2 | L1 | L2 |
| 1 x 30 | 5 | 0 | 5 | 5 | 5 | 5 |
| 2 x 30 | 5 | 3 | 5 | 4 | 5 | 5 |
| 3 x 30 | 5 | 5 | 5 | 5 | 5 | 5 |
| 4 x 30 | 5 | 5 | 5 | 5 | 5 | 5 |
| 6 x 30 | 5 | 5 | 5 | 5 | 5 | 5 |
| Reactivity C58 at 60m/min | 1x | | 2x | | 3x | |
| Density | 1.57 | | 1.42 | | 1.17 | |
| Effect on the roll | Ok | | Ok | | Ok | |

In these tables, the following abbreviations are used:
- DPGDA:: dipropylene glycol diacrylate
- TPGDA:: tripropylene glycol diacrylate
- Solsp:: SOLSPERSE®
- L1:: Ink layer 1 in direct contact with the substrate
- L2:: Ink layer 2 applied on top of layer 1
- C58:: BOPP (Bioriented polypropylene) without adhesion primer

## Claims

1. A radiation curable composition comprising at least one ethylenically unsaturated compound (A); at least one inert polyester resin (B); and at least one inert resin (C) different from (B).

2. The composition of claim 1, wherein the polyester (B) is prepared from a polyol component that comprises ethylene glycol, and from a polycarboxy component that comprises phthalic acid and/or phthalic anhydride or that comprises one or more dialkylesters of phthalic acid.

3. The composition of claim 2, wherein the polyol component comprises from 10 to 100 mole% of ethylene glycol, and optionally from 0 to 90 mole% of other glycols, and wherein the polycarboxy component comprises from 80 to 100 mole% of phthalic acid and/or phthalic anhydride.

4. The composition of any of the preceding claims, wherein the polyester (B) is prepared from phthalic anhydride, from ethylene glycol and, optionally, from neopentyl glycol.

5. The composition of any of the preceding claims, wherein the polyester is further prepared from one or more monocarboxylic compounds (X1).

6. The composition of any of the preceding claims, wherein the inert polyester (B) has a total equivalent ratio of hydroxyl groups from the polyols to carboxyl groups from the polycarboxylic acids that exceeds 1.0.

7. The composition of the preceding claim, wherein the polyester (B) has a number average molecular weight of between 500 and 5000 daltons.

8. The composition of any of the preceding claims, wherein the inert resin (C) is selected from acrylic resins, polystyrene resins, (poly)urethane resins, polyethylenevinyl acetate resins, polyvinylchloride resins, chlorinated polyolefin resins and/or ketone resins.

9. The composition of any of the preceding claims, wherein the inert resin (C) is selected from polystyrene resins and/or acrylic resins.

10. The composition of any of the preceding claims, wherein the inert resin (C) is a polystyrene resin with a number average molecular weight of between 100 and 5000 daltons.

11. The composition of any of the preceding claims comprising at least 10% by weight of inert resins (B) and (C).

12. The composition of any of the preceding claims, wherein the ethylenically unsaturated compound (A) comprises at least one (meth)acrylated compound selected from di(meth)acrylates and/or tri(meth)acrylates.

13. The composition of any of the preceding claims, further comprising a photoinitiator and, optionally a photoactivator.

14. A coating composition, ink or varnish comprising a composition according to any of the claims 1 to 13.

15. An article coated, partially or entirely, with a composition according to any of the claim 14.
